# EUROPEAN PATENT SPECIFICATION

(11) **EP 3 960 683 B1**
(45) Date of publication and mention of the grant of the patent: **24.01.2024**
(21) Application number: 20193539.2
(22) Date of filing: 31.08.2020
(51) Int. Cl.: H05K 5/02, B66B 11/00, B66B 25/00

(54) **ELEVATOR CONTROL CABINET, ELEVATOR SYSTEM, CONVEYOR SYSTEM CONTROL CABINET AND CONVEYOR SYSTEM**
AUFZUGSTEUERSCHRANK, AUFZUGSANLAGE, FÖRDERSYSTEMSCHALTSCHRANK UND FÖRDERSYSTEM
ARMOIRE DE COMMANDE D'ASCENSEUR, SYSTÈME D'ASCENSEUR, ARMOIRE DE COMMANDE DE SYSTÈME DE CONVOYEUR ET SYSTÈME DE CONVOYEUR

(43) Date of publication of application: 02.03.2022
(73) Proprietor: KONE Corporation, 00330 Helsinki (FI)
(72) Inventor: TALONEN, Tapani, 00330 Helsinki (FI)
(74) Representative: K & H Bonapat Patentanwälte Koch · von Behren & Partner mbB

(56) References cited:
- WO-A1-2006/024894
- WO-A1-2015/015639
- CN-U- 206 402 631
- CN-U- 207 192 508
- KR-A- 20190 054 568

## Description

### FIELD OF THE INVENTION

The present invention relates to an elevator control cabinet, an elevator system comprising said elevator control cabinet, a conveyor system control cabinet and conveyor system, wherein the control cabinet offers improved choices of installation locations and ensures safe operation in case of a fire situation.

### BACKGROUND OF THE INVENTION

Elevator control components are enclosed in an elevator control cabinet to prevent unauthorized access as well as to facilitate maintenance and inspection operations. Such a cabinet is customarily mounted inside an elevator shaft or at a landing, for example next to a landing door.

Components inside the control cabinet contain combustible material and therefore must be considered for fire protection. Traditionally, elevator landing floors are sealed in a fire situation such that a shaft-mounted control cabinet is secured inside the shaft. This means that flue gases from the shaft cannot reach the landing, and consequently, an emergency exit way of the landing.

In case of a landing-mounted cabinet, there is normally a wall opening from the control cabinet to the shaft such that an interior of the control cabinet mixes with the shaft volume. In other words, it is part of the shaft volume, not part of the landing. The problem with such an arrangement is that the control cabinet must be located exactly at the wall opening, which may be inflexible.

Furthermore, fire protection guidelines stipulate that if elevator controls are located outside the elevator shaft they must be integrated in the shaft front and have at least the same fire resistance as the shaft doors as well as be smoke-tight to the landing. In addition, the controls must be freestanding or in the wall recess and have a predefined fire resistance or be located in a separate fire compartment, in a cabinet made of RF1 building materials. Furthermore, connections such as cables, hydraulic lines, etc. between fire compartments shall be protected accordingly.

This poses the problem that since the elevator drive located in the control cabinet requires cooling a cooling air flow from outside the cabinet must be allowed to pass through said cabinet. When a drive cooling-fan is operating, there is thus a need for air vents to be arranged in said control cabinet.

This in turn makes it difficult to make the cabinet smoke-tight compared to a regular control cabinet without a cooling air flow requirement. Moreover, when installing said control cabinet at a landing, there is limited space available. With the control cabinet containing an elevator drive and additionally providing sufficient fire insulation, the size of the control cabinet may exceed the available space. CN 20 640 263 U discloses an elevator control cabinet according to the preamble of claim 1. WO 2015 015 639 shows a conveyor system control cabinet.

### AIM OF THE INVENTION

It is thus an object of the present invention to provide an elevator control cabinet and an elevator system that provide an improved flexibility for installing the elevator control cabinet inside or outside an elevator shaft. In addition, said elevator control cabinet which contains at least one elevator power component which requires cooling allows for sufficient cooling while at the same time providing fire protection for the combustible materials contained in the control cabinet.

### SUMMARY OF THE INVENTION

To solve the above-mentioned object, the present invention provides an elevator control cabinet comprising at least one elevator power component arranged inside the elevator control cabinet.

Furthermore, the elevator control cabinet comprises at least one ventilation opening adapted to provide an air flow inside the elevator control cabinet for cooling the at least one elevator power component.

Furthermore, the elevator control cabinet comprises a hatch being arranged at the at least one ventilation opening, the hatch being controllable by an actuator, wherein the actuator is configured to set the hatch to a first position, in which the hatch clears the ventilation opening and to a second position, in which the hatch seals the ventilation opening.

Term "hatch" according to the invention connotes also controllable sealing means, for example seal elements controllable by an actuator, such as magnetic seals controllable by an electromagnet.

In addition, the actuator is configured to set the hatch to the second position based on detection of a fire by a fire sensor.

Furthermore, the present invention provides an elevator system comprising an elevator car movable along an elevator shaft and the elevator control cabinet according to the present invention.

It is an idea of the present invention to arrange a hatch at the at least one ventilation opening. Due to the fact that said hatch is controllable by means of an actuator, it is able to assume an open position as well as a closed position thus ensuring sufficient ventilation of the at least one elevator power component arranged inside the elevator control cabinet as well as to seal the ventilation opening smoke-tight in case of detection of a fire by a fire sensor.

According to a further aspect of the invention, the fire sensor, in particular a smoke sensor and/or a temperature sensor, is arranged inside or outside the elevator control cabinet, is connected to the actuator directly or via an elevator control unit located within the elevator control cabinet and/or is part of a building fire alarm system.

According to an embodiment, the elevator control cabinet comprises the fire sensor.

Thus, an improved flexibility for the placement of the elevator control cabinet can be achieved. Furthermore, the fire sensor can be placed inside and/or outside the elevator control cabinet such that an optimal position can be found in order to accurately detect a fire situation in a vicinity of the elevator control cabinet or in other parts of the building.

According to a further aspect of the invention, the elevator control cabinet comprises an elevator drive unit arranged inside the elevator control cabinet. In this way, the at least one ventilation opening that can be opened and closed by means of the hatch driven by the actuator is able to provide an air flow inside the elevator control cabinet for cooling the at least one elevator power component in a normal operating condition of the elevator.

According to a further aspect of the invention, a cabinet door and/or the hatch is smoke-insulated. Thus, when the hatch is placed in the second position effectively sealing the at least one ventilation opening, the elevator control cabinet can be effectively insulated from any detected heat and/or smoke outside the elevator control cabinet.

According to a further aspect of the invention, the elevator control cabinet comprises a first ventilation opening, in particular an air inlet, arranged at a first side of the elevator control cabinet, wherein a first hatch is arranged at the first ventilation opening, said first hatch being controllable by a first actuator, and wherein the elevator control cabinet comprises a second ventilation opening, in particular an air outlet, arranged at a second side of the elevator control cabinet, wherein a second hatch is arranged at the second ventilation opening, said second hatch being controllable by a second actuator.

By providing a first ventilation opening and a second ventilation opening, each of which can be opened and closed by means of a controllable hatch driven by a respective actuator a sufficient ventilation of the at least one elevator power component can be achieved during a normal operation of an elevator system. In the case when a fire is detected by the fire sensor, the elevator control cabinet can hence be effectively protected such that the combustible components installed in the elevator control cabinet can continue to safely function.

According to a further aspect of the invention, an elevator control unit is configured to control the actuator to set the hatch to the first position if no fire is detected by the fire sensor and if the elevator power component requires cooling, an air flow generating device, in particular a fan, is operational, an elevator drive unit is operational and/or power is supplied to the elevator drive unit. Thus, advantageously a cooling air flow is generated when cooling of the elevator power component is required.

According to a further aspect of the invention, the elevator control unit is configured to interrupt operation of an elevator car or to control the elevator drive unit to move the elevator car to a nearest landing responsive to detection of fire by the fire sensor. The elevator is thus still operational in case of a detected fire and it is possible to safely evacuate any passengers that may be present in the elevator car at this time.

According to a further aspect of the invention, the actuator is formed by a spindle drive or a solenoid valve, wherein a pull-up current of the solenoid valve is greater than a hold-up current of the solenoid valve. Thus, if the actuator is formed by a solenoid valve, the valve is held open by the hold-up current during a normal operation of the elevator system.

Should a fire be detected by the fire sensor, a power supply to the solenoid valve is interrupted causing actuation typically by a spring force thus moving the hatch to close the at least one ventilation opening of the elevator control cabinet. When the solenoid valve is energized again in order to open the hatch to clear the at least one ventilation opening of the elevator control cabinet, the required pull-up current for actuation is greater than the hold-up current required to hold the solenoid valve against the predefined spring force.

According to a further aspect of the invention, the elevator control unit is configured to interrupt a power supply to the solenoid valve responsive to detecting a fire by the fire sensor, causing the hatch being set to the second position sealing the at least one ventilation opening by a spring force of a spring contained in the solenoid valve. In doing so, a safe operation of the solenoid valve can be ensured, wherein the valve performs its intended function also in case of a power failure as no power is required for its spring-based actuation to move the hatch for sealing the at least one ventilation opening of the elevator control cabinet.

According to a further aspect of the invention, the elevator power component is formed by an elevator drive unit or part of the elevator drive unit such as a motor inverter, a rectifier, a circuit breaker and/or a battery. As these components generate heat during operation, sufficient cooling is required. The elevator control cabinet according to the invention advantageously provides an efficient cooling of said components by providing an air flow around said components in the elevator control cabinet.

According to a further aspect of the invention, wherein the elevator control unit is configured to send a fault or alarm message to a service center, in particular before interrupting elevator operation, when detecting a malfunction of the actuator and/or the fire sensor and/or over-heating-condition of an elevator drive unit and/or battery temperature control.

Thus, a reliable operation of the elevator control unit and its components such as the fire sensor and/or the actuator can be ensured and any necessary replacement of malfunctioning components can be performed in a timely manner.

According to a further aspect of the invention, the elevator control cabinet is located outside of the elevator shaft, in particular at a floor having an emergency exit, or in an elevator shaft front, in particular freestanding, in a wall recess or in a fire compartment of the elevator shaft.

The elevator control cabinet of the present invention thus provides a broad flexibility for locating a suitable installation position that advantageously suits any existing requirements or constraints of a specific installation site.

The herein described features of the elevator control cabinet are also disclosed for the elevator system and vice versa.

A further aspect of the invention is a conveyor system control cabinet comprising at least one conveyor system power component arranged inside the conveyor system control cabinet, at least one ventilation opening adapted to provide an air flow inside the conveyor system control cabinet for cooling the at least one conveyor system power component, an actuator; and a hatch being arranged at the at least one ventilation opening, the hatch being controllable by the actuator, wherein the actuator is configured to set the hatch to a first position, in which the hatch clears the ventilation opening and to a second position, in which the hatch seals the ventilation opening, and wherein the actuator is configured to set the hatch to the second position based on detection of a fire by a fire sensor.

According to an embodiment, the conveyor system control cabinet comprises the fire sensor.

A still further aspect of the invention is a conveyor system, in particular an escalator or a moving walk, comprising an endless conveying band and the conveyor system control cabinet for controlling the conveyor system, said conveyor system control cabinet comprising the conveyor system power component, in particular a conveyor system drive, for moving the conveying band.

Likewise, the conveyor system comprising the conveyor system control cabinet benefits from the advantage of having a hatch that is controllable by means of an actuator and is able to assume an open position as well as a closed position thus ensuring sufficient ventilation of the at least one conveyor system power component arranged inside the conveyor system control cabinet as well as to seal the ventilation opening smoke-tight in case of detection of a fire by a fire sensor.

For a more complete understanding of the present invention and advantages thereof, reference is now made to the following description taken in conjunction with the accompanying drawings. The invention is explained in more detail below using exemplary embodiments, which are specified in the schematic figures of the drawings, in which:
- Fig. 1: shows a schematic diagram of an elevator system according to an embodiment of the invention;
- Fig. 2: shows a cross-sectional view of an elevator and/or conveyor system control cabinet in which air ventilation openings are in an open position according to the embodiment of the invention;
- Fig. 3: shows a cross-sectional view of the elevator and/or conveyor system control cabinet in which air ventilation openings are in a closed position according to the embodiment of the invention; and
- Fig. 4: shows a schematic diagram of an escalator according to a further embodiment of the invention.

Unless indicated otherwise, like reference numbers or signs to the figures indicate like elements.

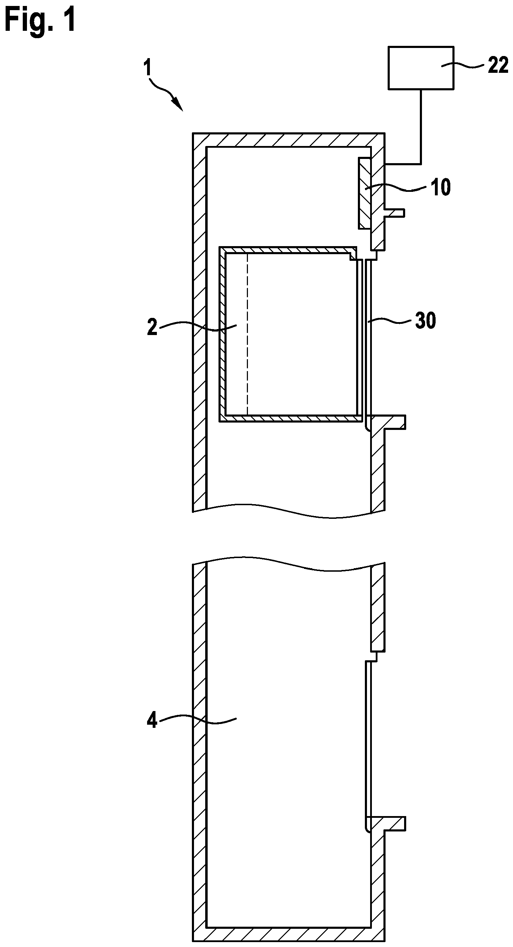

Fig. 1 shows a schematic diagram of an elevator system according to an embodiment of the invention.

The elevator system 1 comprises an elevator car 2 movable along an elevator shaft 4 and an elevator control cabinet 10 installed in an elevator shaft front.

Alternatively, the elevator control cabinet can e.g. be located outside of the elevator shaft, in particular at a floor having an emergency exit or be arranged freestanding in the elevator shaft, in a wall recess or in a fire compartment of the elevator shaft 4.

The elevator car 2 is depicted at a landing 30 adjacent to the elevator control cabinet 10 arranged in the elevator shaft 4. In addition, a fire sensor contained in the elevator control cabinet 10 is connected to a building fire alarm system 22.

In addition, the building fire alarm system may contain several additional fire sensors that are arranged at various locations within the building and can signal a fire alarm to the elevator control cabinet 10 which in turn can trigger the elevator car to be stopped at the nearest landing 30 for a safe evacuation of any passengers contained in the elevator car 2.

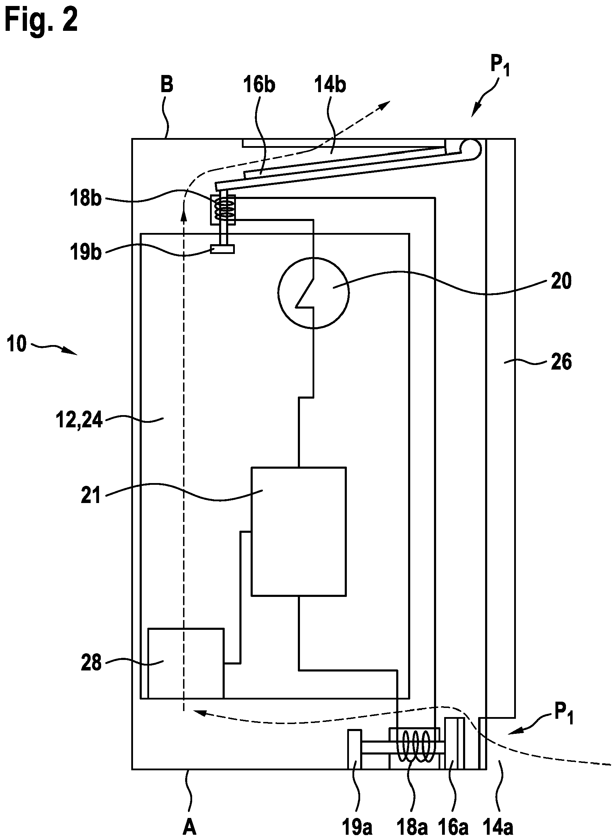

Fig. 2 shows a cross-sectional view of an elevator and/or conveyor system control cabinet in which air ventilation openings are in an open position according to the embodiment of the invention.

The elevator and/or conveyor system control cabinet 10 comprises an elevator power component 12 arranged on the inside of the elevator and/or conveyor system control cabinet 10. The elevator power component is formed by an elevator drive unit 24. Alternatively, the elevator power component 12 can be formed by part of the elevator drive unit 24 such as a motor inverter, a rectifier, a circuit breaker and/or a battery.

In addition, the elevator and/or conveyor system control cabinet 10 comprises a first ventilation opening 14a, in particular an air inlet, arranged at a first side A of the elevator and/or conveyor system control cabinet 10. A first hatch 16a is arranged at the first ventilation opening 14a. Said first hatch 16a is controllable by a first actuator 18a.

The elevator and/or conveyor system control cabinet 10 furthermore comprises a second ventilation opening 14b, in particular an air outlet, arranged at a second side B of the elevator and/or conveyor system control cabinet. The second side B of the elevator and/or conveyor system control cabinet according to the present embodiment is located opposite to the first side A of the elevator and/or conveyor system control cabinet in order to ensure that an air flow passes through the entire elevator and/or conveyor system control cabinet in order to effectively cool the components contained within the elevator and/or conveyor system control cabinet 10.

A second hatch 16b is arranged at the second ventilation opening 14b. Said second hatch 16b is being controllable by a second actuator 18b.

The first actuator 18a is configured to set the first hatch 16a to a first position P1, in which the first hatch 16a clears the first ventilation opening 14a. The depicted first position P1 of the hatch 16a reflects a position suitable for normal operation of the elevator system allowing for an air flow to pass through the elevator and/or conveyor system control cabinet 10.

The first actuator 18a and the second actuator 18b are formed by a solenoid valve essentially comprising a coil that causes an actuation part to move against a spring force. Alternatively, the actuators 18a, 18b can e.g. be formed by a spindle drive.

The elevator and/or conveyor system control cabinet 10 furthermore comprises a control unit 21, an air flow generating device 28, in particular a fan, and the fire sensor 20. In addition, a cabinet door 26 of the elevator and/or conveyor system control cabinet 10 is smoke-insulated.

The fire sensor 20 is connected to the first actuator 18a through the elevator control unit 21 and is directly connected to the second actuator 18b.

Alternatively, the fire sensor 20 can e.g. have a direct connection to both the first actuator 18a and the second actuator 18b or be connected to the first actuator 18a and the second actuator 18b through the elevator control unit 21 or another electronic control unit arranged within the elevator and/or conveyor system control cabinet 10.

The fire sensor 20 is formed by a smoke sensor. Alternatively, the fire sensor 20 can be formed by a temperature sensor or a combined smoke sensor and temperature sensor.

In addition, the fire sensor 20 is arranged inside the elevator and/or conveyor system control cabinet 10. Alternatively, the fire sensor 20 can e.g. be arranged outside the elevator and/or conveyor system control cabinet or both inside and outside the elevator and/or conveyor system control cabinet 10, i.e. by using several fire sensors.

The air flow generating device 28 is connected to the elevator control unit 21, wherein a power signal supplied to the air flow generating device 28 can e.g. be controlled depending on a cooling requirement of the elevator power component 12.

The first actuator 18a is configured to clear the first ventilation opening 14a by moving a plate element in parallel to a wall of the elevator power component 12 that contains the first ventilation opening 14a.

By contrast, the second actuator 18b comprises a plate-like element that can be tilted relatively to a wall of the elevator and/or conveyor system control cabinet 10 that contains the second ventilation opening 14b.

Alternatively, the first actuator 18a and/or the second actuator 18b may be of the same type or modified according to ensure an optimal air flow through the elevator and/or conveyor system control cabinet 10.

The elevator control unit 21 is configured to control the first actuator 18a and the second actuator 18b to set the hatches 16a, 16b to the first position P1 if no fire is detected by the fire sensor 20 and if cooling is required by at least one component contained within the elevator and/or conveyor system control cabinet 10 such as the elevator power component 12, the air flow generating device 28 or an elevator drive unit 24.

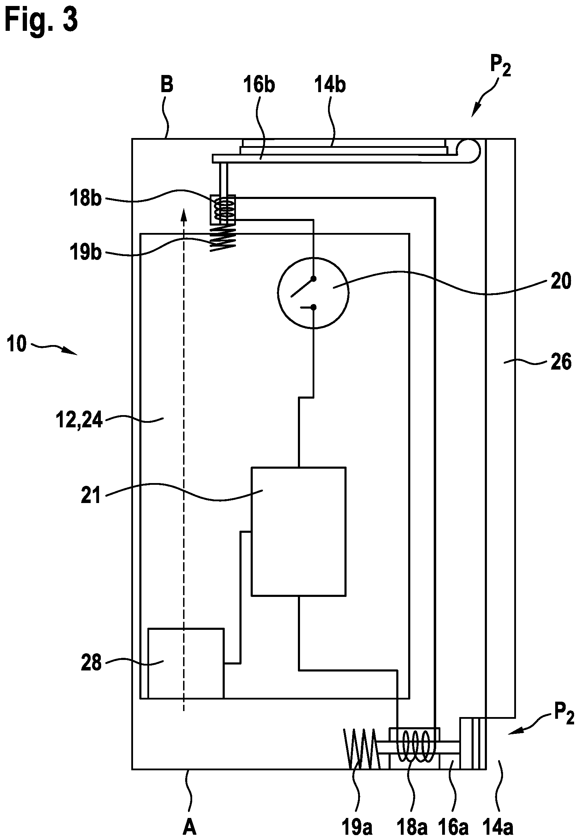

Fig. 3 shows a cross-sectional view of the elevator and/or conveyor system control cabinet in which air ventilation openings are in a closed position according to the embodiment of the invention.

In the present diagram, the first ventilation opening 14a and the second ventilation opening 14b are sealed by the first hatch 16a and the second hatch 16b, e.g. the first actuator 18a and the second actuator 18b set the hatches 16a, 16b to the second position P2 in reaction to detection of a fire by the fire sensor 20. The elevator and/or conveyor system control cabinet 10 is thus smoke-insulated from an exterior of the elevator and/or conveyor system control cabinet 10.

The elevator control unit 21 is configured to interrupt operation of the elevator car 2 or to control the elevator drive unit 24 to move the elevator car 2 to a nearest landing.

When a fire is detected by the fire sensor 20, the elevator control unit 21 is configured to interrupt a power supply to the solenoid valves such that the hatches 16a, 16b are set to the second position P2 sealing the ventilation openings 14a, 14b by a spring force of a spring contained in the solenoid valves, respectively.

In addition, the elevator control unit 21 is configured to send a fault or alarm message to a service center, in particular before interrupting elevator operation, if a malfunction of the actuators 18a, 18b and/or the fire sensor 20 is detected. Furthermore, in a case of failure or malfunction of the elevator drive unit 24 and/or a battery temperature control over-heating-condition is detected, the elevator control unit 21 may also send a fault or alarm message to the service center.

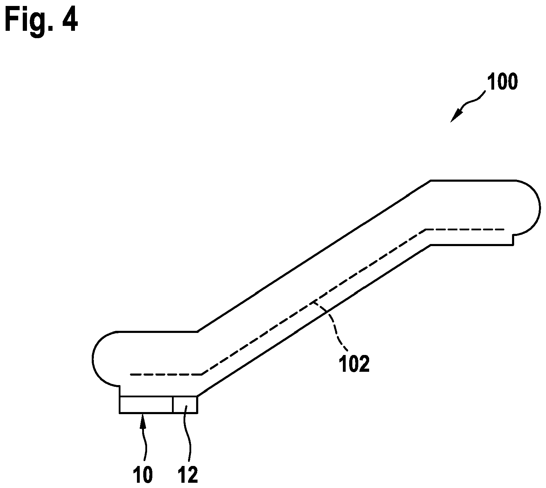

Fig. 4 shows a schematic diagram of an escalator according to a further embodiment of the invention.

In the present diagram a conveyor system 100 is shown. The conveyor system 100 is comprises an escalator. Alternatively, the conveyor system 100 may comprise a moving walk.

Specifically, the conveyor system 100 comprises an endless conveying band 102 and the conveyor system control cabinet 10 for controlling the conveyor system 100, said conveyor system control cabinet 10 comprising the conveyor system power component 12, in particular a conveyor system drive, for moving the conveying band 102.

The conveyor system control cabinet 10 is substantially identical to the elevator control cabinet 10 shown in Figures 2 and 3, apart from the fact that it is adapted for use with the conveyor system 100.

## Claims

1. Elevator / Conveyor system control cabinet (10) comprising:
at least one elevator / conveyor system power component (12) arranged inside the elevator / conveyor system control cabinet (10);
at least one ventilation opening (14a, 14b) adapted to provide an air flow inside the elevator / conveyor system control cabinet (10) for cooling the at least one elevator / conveyor system power component (12);
an actuator; and
a hatch (16a, 16b) being arranged at the at least one ventilation opening (14a, 14b), the hatch (16a, 16b) being controllable by the actuator (18a, 18b), wherein the actuator (18a, 18b) is configured to set the hatch (16a, 16b) to a first position (P1), in which the hatch (16a, 16b) clears the ventilation opening (14a, 14b) and to a second position (P2), in which the hatch (16a, 16b) seals the ventilation opening (14a, 14b), and
**characterized in that** the actuator (18a, 18b) is configured to set the hatch (16a, 16b) to the second position (P2) based on detection of a fire by a fire sensor (20).

2. Elevator control cabinet according to claim 1, wherein the fire sensor (20), in particular a smoke sensor and/or a temperature sensor, is arranged inside or outside the elevator control cabinet (10), is connected to the actuator (18a, 18b) directly or via an elevator control unit (21) located within the elevator control cabinet (10) and/or is part of a building fire alarm system (22).

3. Elevator control cabinet according to claim 1 or 2, wherein the elevator control cabinet (10) comprises an elevator drive unit (24) arranged inside the elevator control cabinet (10).

4. Elevator control cabinet according to any of the preceding claims, wherein a cabinet door (26) and/or the hatch (16a, 16b) is smoke-insulated.

5. Elevator control cabinet according to any of the preceding claims, wherein the elevator control cabinet (10) comprises a first ventilation opening (14a), in particular an air inlet, arranged at a first side (A) of the elevator control cabinet (10), wherein a first hatch (16a) is arranged at the first ventilation opening (14a), said first hatch (16a) being controllable by a first actuator (18a), and wherein the elevator control cabinet (10) comprises a second ventilation opening (14b), in particular an air outlet, arranged at a second side (B) of the elevator control cabinet (10), wherein a second hatch (16b) is arranged at the second ventilation opening (14b), said second hatch (16b) being controllable by a second actuator (18b).

6. Elevator control cabinet according to any of the preceding claims, wherein an elevator control unit (21) is configured to control the actuator (18a, 18b) to set the hatch (16a, 16b) to the first position (P1) if no fire is detected by the fire sensor (20) and if the elevator power component (12) requires cooling, an air flow generating device (28), in particular a fan, is operational, an elevator drive unit (24) is operational and/or power is supplied to the elevator drive unit (24).

7. Elevator control cabinet according to claim 6, wherein the elevator control unit (21) is configured to interrupt operation of an elevator car or to control the elevator drive unit (24) to move the elevator car to a nearest landing (30) responsive to detection of fire by the fire sensor (20).

8. Elevator control cabinet according to any of the preceding claims, wherein the actuator (18a, 18b) is formed by a spindle drive or a solenoid valve, wherein a pull-up current of the solenoid valve is greater than a hold-up current of the solenoid valve.

9. Elevator control cabinet according to claim 8, wherein the elevator control unit (21) is configured to interrupt a power supply to the solenoid valve responsive to detecting a fire by the fire sensor (20), causing the hatch (16a, 16b) being set to the second position (P2) sealing the at least one ventilation opening (14a, 14b) by a spring force of a spring contained in the solenoid valve.

10. Elevator control cabinet according to any of the preceding claims, wherein the elevator power component (12) is formed by an elevator drive unit (24) or part of the elevator drive unit (24) such as a motor inverter, a rectifier, a circuit breaker and/or a battery.

11. Elevator control cabinet according to any of claims 6 to 10, wherein the elevator control unit (21) is configured to send a fault or alarm message to a service center, in particular before interrupting elevator operation, when detecting a malfunction of the actuator (18a, 18b) and/or the fire sensor (20) and/or over-heating-condition of an elevator drive unit (24) and/or battery temperature control.

12. Elevator system (1) comprising an elevator car (2) movable along an elevator shaft (4), and an elevator control cabinet (10) having the features of any one of claims 1 to 10.

13. Elevator system according to claim 12, wherein the elevator control cabinet (10) is located outside of the elevator shaft (4), in particular at a floor having an emergency exit, or in an elevator shaft front, in particular freestanding, in a wall recess or in a fire compartment of the elevator shaft (4).

14. Conveyor system (100), in particular an escalator or a moving walk, comprising an endless conveying band (102) and the conveyor system control cabinet (10) of claim 1 for controlling the conveyor system (100), said conveyor system control cabinet (10) comprising the conveyor system power component (104), in particular a conveyor system drive, for moving the conveying band (102).

## Patentansprüche

1. Schaltschrank (10) für ein Aufzugs-/Fördersystem, aufweisend:
mindestens eine Leistungsversorgungs-Komponente (12) für das Aufzugs-/Fördersystem, die im Schaltschrank (10) des Aufzugs-/Fördersystems angeordnet ist;
mindestens eine Belüftungsöffnung (14a, 14b), die adaptiert sind, einen Luftstrom im Schaltschrank (10) des Aufzugs-/Fördersystems zur Kühlung der mindestens einen Leistungsversorgungs-Komponente (12) des Aufzugs-/Fördersystems bereitzustellen;
ein Stellglied; und
eine Luke (16a, 16b), die an der mindestens einen Lüftungsöffnung (14a, 14b) angeordnet ist, wobei die Luke (16a, 16b) durch den Aktuator (18a, 18b) steuerbar ist, wobei der Aktuator (18a, 18b) konfiguriert ist, um die Luke (16a, 16b) in eine erste Position (P1) zu setzen, in der die Luke (16a, 16b) die Lüftungsöffnung (14a, 14b) freigibt, und in eine zweite Position (P2), in der die Luke (16a, 16b) die Lüftungsöffnung (14a, 14b) verschließt, und
**dadurch gekennzeichnet, dass** der Aktuator (18a, 18b) so konfiguriert ist, dass er die Luke (16a, 16b) auf der Grundlage der Erkennung eines Feuers durch einen Brandsensor (20) in die zweite Position (P2) bringt.

2. Aufzugs-Schaltschrank nach Anspruch 1, wobei der Brandsensor (20), insbesondere ein Rauchsensor und/oder ein Temperatursensor, innerhalb oder außerhalb des Aufzugsschaltschranks (10) angeordnet ist/sind, und direkt an dem Stellantrieb (18a, 18b) oder über eine innerhalb des Aufzugs-Schaltschranks (10) vorgesehene Aufzugssteuerungseinheit (21) an dem Stellantrieb (18a, 18b) angeschlossen ist/sind, und/oder Teil einer Gebäudebrandmeldeanlage (22) ist.

3. Aufzugs-Schaltschrank nach Anspruch 1 oder 2, wobei der Aufzugs-Schaltschrank (10) eine Aufzugsantriebseinheit (24) umfasst, die im Aufzugs-Schaltschrank (10) angeordnet ist.

4. Aufzugs-Schaltschrank nach einem der vorhergehenden Ansprüche, wobei eine Schranktür (26) und/oder die Luke (16a, 16b) ist rauchdicht isoliert ist/sind.

5. Aufzugs-Schaltschrank nach einem der vorhergehenden Ansprüche, wobei der Aufzugs-Schaltschrank (10) eine erste Lüftungsöffnung (14a), insbesondere einen Lufteinlass, aufweist, die an einer ersten Seite (A) des Aufzugsschaltschranks (10) angeordnet ist, wobei an der ersten Belüftungsöffnung (14a) eine erste Luke (16a) angeordnet ist, die durch einen ersten Aktuator (18a) steuerbar ist, und wobei der Aufzugs-Schaltschrank (10) eine zweite Belüftungsöffnung (14b), insbesondere einen Luftauslass, aufweist, die an einer zweiten Seite (B) des Aufzugs-Schaltschranks (10) angeordnet ist, wobei an der zweiten Belüftungsöffnung (14b) eine zweite Luke (16b) angeordnet ist, und die zweite Luke (16b) durch ein zweites Stellglied (18b) steuerbar ist.

6. Aufzugs-Schaltschrank nach einem der vorhergehenden Ansprüche, wobei eine Aufzugssteuereinheit (21) so konfiguriert ist, dass sie den Aktuator (18a, 18b) steuert, um die Luke (16a, 16b) in die erste Position (P1) zu setzen, wenn kein Feuer durch den Brandsensor (20) erkannt wird und wenn die Aufzugs-Leistungsversorgungs-Komponente (12) gekühlt werden muss, sowie eine Luftstromerzeugungsvorrichtung (28), insbesondere ein Ventilator, in Betrieb nehmen kann, ferner eine Aufzugsantriebseinheit (24) und/oder die Aufzugsantriebseinheit (24) mit Strom versorgt.

7. Aufzugs-Schaltschrank nach Anspruch 6, wobei die Aufzugssteuereinheit (21) so konfiguriert ist, dass sie den Betrieb einer Aufzugskabine unterbricht oder die Aufzugsantriebseinheit (24) dahingehend steuert, die Aufzugskabine in Reaktion auf die Erkennung eines Feuers durch den Brandsensor (20) zu einem nächstgelegenen Stockwerk (30) zu fahren.

8. Aufzugs-Schaltschrank nach einem der vorhergehenden Ansprüche, wobei der Aktuator (18a, 18b) durch einen Spindelantrieb oder ein Magnetventil gebildet ist, wobei ein Anzugsstrom des Magnetventils größer ist als ein Haltestrom des Magnetventils.

9. Aufzugs-Schaltschrank nach Anspruch 8, wobei die Aufzugssteuereinheit (21) so konfiguriert ist, dass sie die Stromversorgung des Magnetventils unterbricht, wenn der Brandsensor (20) einen Brand erkennt, wodurch die Luke (16a, 16b) durch die Federkraft einer im Magnetventil enthaltenen Feder in die zweite Position (P2) gebracht wird, die die mindestens eine Lüftungsöffnung (14a, 14b) verschließt.

10. Aufzugs-Schaltschrank nach einem der vorhergehenden Ansprüche, wobei die Aufzugs-Leistungsversorgungs-Komponente (12) gebildet ist durch eine Aufzugsantriebseinheit (24) oder durch einen Teil der Aufzugsantriebseinheit (24), wie z.B. einen Motorumrichter, einen Gleichrichter, einen Leistungsschalter 5 und/oder eine Batterie.

11. Aufzugs-Schaltschrank nach einem der vorhergehenden Ansprüche 6 bis 10, wobei die Aufzugssteuereinheit (21) so konfiguriert ist, dass sie bei Erkennen einer Fehlfunktion des Aktuators (18a, 18b) und/oder des Brandsensors (20) und/oder eines Überhitzungszustands einer Aufzugsantriebseinheit (24) und/oder einer Batterie-Temperatursteuerung eine Fehler- oder Alarmmeldung an eine Servicezentrale sendet, insbesondere bevor der Aufzugsbetrieb unterbrochen wird.

12. Aufzugssystem (1) mit einer Aufzugskabine (2), die entlang eines Aufzugsschachtes (4) verfahrbar ist, und einem Aufzugs-Schaltschrank (10) mit den Merkmalen eines der Ansprüche 1 bis 10.

13. Aufzugssystem nach Anspruch 12, wobei der Aufzugs-Schaltschrank (10) außerhalb des Aufzugsschachtes (4), insbesondere in einem Stockwerk mit einem Notausgang, oder in einer Aufzugsschachtfront, insbesondere freistehend, in einer Wandnische oder in einer Brandkammer des Aufzugsschachtes (4) angeordnet ist.

14. Förderanlage (100), insbesondere eine Rolltreppe oder ein Fahrsteig, mit einem endlosen Förderband (102) und dem Förderanlagen-Schaltschrank (10) nach Anspruch 1 zur Steuerung der Förderanlage (100), wobei der Förderanlagen-Schaltschrank (10) die Förderanlagen-Leistungsversorgungs-Komponente (104) zum Bewegen des Förderbandes (102) aufweist, insbesondere ein Förderanlagenantriebs-System.

## Revendications

1. Armoire de commande d'ascenseur / de système de convoyeur (10) comprenant :
au moins un composant électrique d'ascenseur / de système de convoyeur (12) agencé à l'intérieur de l'armoire de commande d'ascenseur / de système de convoyeur (10) ;
au moins une ouverture de ventilation (14a, 14b) adaptée à fournir un flux d'air à l'intérieur de l'armoire de commande d'ascenseur / de système de convoyeur (10) pour refroidir l'au moins un composant électrique d'ascenseur / système de convoyeur (12) ;
un actionneur ; et
une trappe (16a, 16b) qui est agencée au niveau de l'au moins une ouverture de ventilation (14a, 14b), la trappe (16a, 16b) pouvant être commandée par l'actionneur (18a, 18b), dans laquelle l'actionneur (18a, 18b) est configuré pour régler la trappe (16a, 16b) dans une première position (PI), dans laquelle la trappe (16a, 16b) dégage l'ouverture de ventilation (14a, 14b) et dans une seconde position (P2), dans laquelle la trappe (16a, 16b) ferme hermétiquement l'ouverture de ventilation (14a, 14b), et
**caractérisée en ce que** l'actionneur (18a, 18b) est configuré pour régler la trappe (16a, 16b) dans la seconde position (P2) sur la base de la détection d'un incendie par un détecteur d'incendie (20).

2. Armoire de commande d'ascenseur selon la revendication 1, dans laquelle le détecteur d'incendie (20), en particulier un détecteur de fumée et/ou un capteur de température, est agencé à l'intérieur ou à l'extérieur de l'armoire de commande d'ascenseur (10), est relié à l'actionneur (18a, 18b) directement ou par le biais d'une unité de commande d'ascenseur (21) située à l'intérieur de l'armoire de commande d'ascenseur (10) et/ou fait partie d'un système d'alarme incendie de bâtiment (22).

3. Armoire de commande d'ascenseur selon la revendication 1 ou 2, dans laquelle l'armoire de commande d'ascenseur (10) comprend une unité d'entraînement d'ascenseur (24) agencée à l'intérieur de l'armoire de commande d'ascenseur (10).

4. Armoire de commande d'ascenseur selon une quelconque des revendications précédentes, dans laquelle une porte d'armoire (26) et/ou la trappe (16a, 16b) est isolée contre les fumées.

5. Armoire de commande d'ascenseur selon une quelconque des revendications précédentes, dans laquelle l'armoire de commande d'ascenseur (10) comprend une première ouverture de ventilation (14a), en particulier une entrée d'air, agencée au niveau d'un premier côté (A) de l'armoire de commande d'ascenseur (10), dans laquelle une première trappe (16a) est agencée au niveau de la première ouverture de ventilation (14a), ladite première trappe (16a) pouvant être commandée par un premier actionneur (18a), et dans laquelle l'armoire de commande d'ascenseur (10) comprend une seconde ouverture de ventilation (14b), en particulier une sortie d'air, agencée au niveau d'un second côté (B) de l'armoire de commande d'ascenseur (10), dans laquelle une seconde trappe (16b) est agencée au niveau de la seconde ouverture de ventilation (14b), ladite seconde trappe (16b) pouvant être commandée par un second actionneur (18b).

6. Armoire de commande d'ascenseur selon une quelconque des revendications précédentes, dans laquelle une unité de commande d'ascenseur (21) est configurée pour commander l'actionneur (18a, 18b) de régler la trappe (16a, 16b) dans la première position (PI) lorsqu'aucun incendie n'est détecté par le détecteur d'incendie (20) et lorsque le composant électrique d'ascenseur (12) requiert un refroidissement, un moyen de génération de flux d'air (28), en particulier un ventilateur, est opérationnel, une unité d'entraînement d'ascenseur (24) est opérationnelle et/ou l'électricité est alimentée vers l'unité d'entraînement d'ascenseur (24).

7. Armoire de commande d'ascenseur selon la revendication 6, dans laquelle l'unité de commande d'ascenseur (21) est configurée pour interrompre le fonctionnement d'une cabine d'ascenseur ou pour commander l'unité d'entraînement d'ascenseur (24) de déplacer la cabine d'ascenseur vers un palier (30) le plus proche en réponse à la détection d'incendie par le détecteur d'incendie (20).

8. Armoire de commande d'ascenseur selon une quelconque des revendications précédentes, dans laquelle l'actionneur (18a, 18b) est formé d'une commande de broches ou d'une électrovanne de commande, dans laquelle un courant de rappel vers le haut de l'électrovanne de commande est supérieur à un courant de maintien de l'électrovanne de commande.

9. Armoire de commande d'ascenseur selon la revendication 8, dans laquelle l'unité de commande d'ascenseur (21) est configurée pour interrompre une alimentation électrique vers l'électrovanne de commande en réponse à la détection d'un incendie par le détecteur d'incendie (20), amenant la trappe (16a, 16b) à être réglée dans la seconde position (P2) qui ferme hermétiquement l'au moins une ouverture de ventilation (14a, 14b) par une force de ressort d'un ressort contenu dans l'électrovanne de commande.

10. Armoire de commande d'ascenseur selon une quelconque des revendications précédentes, dans laquelle le composant électrique d'ascenseur (12) est formé d'une unité d'entraînement d'ascenseur (24) ou d'une partie de l'unité d'entraînement d'ascenseur (24) tel qu'un inverseur de moteur, un redresseur, un disjoncteur et/ou une batterie.

11. Armoire de commande d'ascenseur selon une quelconque des revendications 6 à 10, dans laquelle l'unité de commande d'ascenseur (21) est configurée pour envoyer un message d'anomalie ou d'alarme à un centre d'entretien, en particulier avant d'interrompre le fonctionnement de l'ascenseur, lors de la détection d'un dysfonctionnement de l'actionneur (18a, 18b) et/ou du détecteur d'incendie (20) et/ou d'un état de surchauffe d'une unité d'entraînement d'ascenseur (24) et/ou d'une commande de température de batterie.

12. Système d'ascenseur (1) comprenant une cabine d'ascenseur (2) déplaçable le long d'une cage d'ascenseur (4) et une armoire de commande d'ascenseur (10) présentant les caractéristiques selon une quelconque des revendications 1 à 10.

13. Système d'ascenseur selon la revendication 12, dans lequel l'armoire de commande d'ascenseur (10) est située à l'extérieur de la cage d'ascenseur (4), en particulier au niveau d'un étage présentant une sortie de secours, ou à l'avant d'une cage d'ascenseur, en particulier de manière autoportante, dans une niche murale ou dans un compartiment coupe-feu de la cage d'ascenseur (4).

14. Système de convoyeur (100), en particulier escalier roulant ou trottoir roulant, comprenant une bande transporteuse sans fin (102) et l'armoire de commande de système de convoyeur (10) selon la revendication 1 pour commander le système de convoyeur (100), ladite armoire de commande de système de convoyeur (10) comprenant le composant électrique de système de convoyeur (104), en particulier un entraînement de système de convoyeur, pour déplacer la bande transporteuse (102).
